# EUROPÄISCHE PATENTSCHRIFT

(11) **EP 2 463 399 B1**
(45) Veröffentlichungstag und Bekanntmachung des Hinweises auf die Patenterteilung: **22.10.2014**
(21) Anmeldenummer: 10194110.2
(22) Anmeldetag: 08.12.2010
(51) Int. Cl.: C23C 14/16

(54) **Magnesiumbauteile mit verbessertem Korrosionsschutz**
Magnesium components with improved corrosion resistance
Composants de magnésium dotés d'une protection contre la corrosion améliorée

(43) Veröffentlichungstag der Anmeldung: 13.06.2012
(73) Patentinhaber: Helmholtz-Zentrum Geesthacht Zentrum für Material- und Küstenforschung GmbH, 21502 Geesthacht (DE)
(72) Erfinder: Störmer, Michael, 21031, Hamburg (DE); Blawert, Carsten, 21481, Lauenburg (DE); Huang, Yuanding, 21502, Geesthacht (DE); Höche, Daniel, 22111, Hamburg (DE); Dietzel, Wolfgang, 21502, Geesthacht (DE); Kainer, Karl Ulrich, 21522, Hohnstorf (DE)
(74) Vertreter: UEXKÜLL & STOLBERG

(56) Entgegenhaltungen:
- JP-A- 2001 207 255
- BOHNE Y ET AL: "Deposition and properties of novel microcrystalline Mg alloy coatings", SURFACE ENGINEERING, INSTITUT OF MATERIALS, LONDON, GB, Bd. 23, Nr. 5, 1. Januar 2007 (2007-01-01) , Seiten 339-343, XP008131978, ISSN: 0267-0844
- SCHLUTER K ET AL: "Comparison of the corrosion behaviour of bulk and thin film magnesium alloys", CORROSION SCIENCE, OXFORD, GB, Bd. 52, Nr. 12, 1. Dezember 2010 (2010-12-01), Seiten 3973-3977, XP027394959, ISSN: 0010-938X [gefunden am 2010-08-12]
- OLK C H ET AL: "Growth and structure of a combinatorial array of mixed-phase magnesium-aluminum thin-film alloys", APPLIED PHYSICS A; MATERIALS SCIENCE & PROCESSING, SPRINGER, BERLIN, DE, Bd. 88, Nr. 2, 23. Mai 2007 (2007-05-23), Seiten 249-253, XP019515498, ISSN: 1432-0630, DOI: DOI:10.1007/S00339-007-4015-8
- Y. BOHNE,C. BLAWERT,, W. DIETZEL, S. MÄNDL: "formation and corrosion properties of mg-ti alloys prepared by physical vapour deposition", PLASMA PROCESS. POLYM., Bd. 4, 2007, Seiten S584-S587, XP002619585,
- BOHNE Y ET AL: "Influence of ion energy on properties of Mg alloy thin films formed by ion beam sputter deposition", SURFACE AND COATINGS TECHNOLOGY, ELSEVIER, AMSTERDAM, NL, Bd. 200, Nr. 22-23, 20. Juni 2006 (2006-06-20), Seiten 6527-6532, XP024995837, ISSN: 0257-8972, DOI: DOI:10.1016/J.SURFCOAT.2005.11.088 [gefunden am 2006-06-20]
- C. BLAWERT, V. HEITMANN, N. SCHARNAGL, M. STÖRMER, J. LUTZ, A. PRAGER-DUSCHKE, D. MANOVA, S. MÄNDL: "different underlying corrosion mechanism for mg bulk alloys and mg thin films", PLASMA PROCESS. POLYM., Bd. 6, 2009, Seiten S690-S694, XP002619586,
- DATABASE COMPENDEX [Online] ENGINEERING INFORMATION, INC., NEW YORK, NY, US; April 2005 (2005-04), YAMAGUCHI T ET AL: "Mg-Si film deposition on magnesium alloy and its characteristics by employing Mg2Si sintered material", XP002619587, Database accession no. E2005299220050 & T. YAMAGUCHI, KONDOH K., T. SERIKAWA, M. HENMI, H. OGINUMA: "Mg-si film deposition on magnesium alloy and its characteristics by employing mg2si sintered material", FUNTAI OYOBI FUMMATSU YAKIN/JOURNAL OF THE JAPAN SOCIETY OF POWDER AND POWDER METALLURGY APRIL 2005 FUNTAI FUNAMTSU YAKIN KYOKAI/JAPAN SOC. OF POWDER METALLURGY JP, Bd. 52, Nr. 4, April 2005 (2005-04), Seiten 276-281,

## Beschreibung

Die vorliegende Erfindung betrifft Magnesiumbauteile mit verbessertem Korrosionsschutz.

### Hintergrund der Erfindung

Mit den stetig wachsenden Anforderungen an die Energieeffizienz verschiedener Produkte spielt der werkstofftechnische Leichtbau eine immer größere Rolle bei der Entwicklung neuer Produkte. Hier werden schon seit längerer Zeit Magnesiumlegierungen auf Grund ihres günstigen Festigkeits- zu Dichteverhältnisses verwendet. Das größte Hemmnis für den Einsatz von Magnesiumlegierungen ist aber immer noch die mangelnde Korrosionsbeständigkeit von ungeschützten Oberflächen. Spezielle Einsatzgebiete in der Automobilindustrie und der Luftfahrt bleiben dieser Werkstoffgruppe aus diesem Grund noch verschlossen.

In Abwesenheit von Feuchtigkeit reagiert Magnesium mit Luftsauerstoff zu Magnesiumoxid (MgO), welches eine sehr dünne graue Schicht auf der Werkstoffoberfläche bildet. Magnesiumoxid besitzt ein kleineres molares Volumen als die darunter liegende Magnesiummatrix und bildet daher eine poröse Schicht aus. Das sogenannte Pilling-Bedworth-Verhältnis beschreibt den Quotienten aus molarem Volumen des schichtbildenden Oxids und dem molaren Volumen des Grundwerkstoffs und beträgt bei Magnesium 0,84. Magnesiumoxid kann den Werkstoff deshalb nicht so gut schützen, wie beispielsweise sich auf Aluminiumwerkstoffen bildendes Aluminiumoxid, welches ein Pilling-Bedworth-Verhältnis von 1,38 aufweist.

Das Korrosionsverhalten von Magnesiumbauteilen ist nicht nur von der Luftfeuchtigkeit, sondern auch von der chemischen Zusammensetzung der Atmosphäre abhängig. Die verschiedenen Magnesiumwerkstoffe zeigen als Korrosionsformen flächigen und lochartigen Angriff. Die typische Korrosionsrate beträgt für Magnesiumwerkstoffe 0,5 bis 50 mm/Jahr.

Der Korrosionsschutz von Magnesiumbauteilen findet üblicherweise durch Aufbringen von Schutzschichten auf das Bauteil statt. Schutzschichten unterteilt man gewöhnlich in die folgenden Kategorien: (a) chemische Konversionsschichten, (b) elektrochemische Schutzschichten, (c) nicht-metallische Schutzschichten und (d) physikalisch veränderte Oberflächen.

Y. Bohne et al. "Deposition and properties of novel mycrocrystalline Mg alloy coatings", Surface Engineering, Institut of Materials, Bd. 23, Nr. 5, Seiten 339-343(2007) offenbart Korrosionsschutzschichten aus einer Magnesium-Aluminiumlegierung auf Bauteilen aus Magnesiumlegierungen und Verfahren zu dessen Herstellung.

Chemische Konversionsschichten bilden sich bei der Behandlung in wässrigen, chromsäurehaltigen Lösungen. Neuerdings werden für die Elektro-, Elektronik- und Autoindustrie auch die RoHSkonformen Konversionsschichten angeboten. Diese sind dann statt Cr⁶⁺-haltig nur noch Cr³⁺-haltig oder gar chromfrei. Die Chromatierschichten sind sehr dünn und bewirken keine oder nur minimale Masseveränderungen. Je nach Anwendung werden transparente oder gelbe Chromatierschichten eingesetzt. Aufgrund der geringen Abriebfestigkeiten bietet die chemische Konversionsschicht keinen Schutz vor mechanischem Verschleiß.

Eine weitere Möglichkeit zur Herstellung eines Korrosionsschutzes für Magnesiumbauteile ist die Ausbildung elektrochemischer Schichten, beispielsweise durch Anodisierung oder plasmaelektrolytischer Oxidation. Zur Anodisierung von Magnesium sind mehrere Verfahren verfügbar, wie beispielsweise a) HAE, b) Magoxid-Coat und in neuerer Zeit das c) Anomag Verfahren. Das HAE-Verfahren wird als ein Fluorid-Anodisieren oder ein galvanisches Anodisieren unter Anwendung von Wechselstrom betrachtet. HAE-Schichten sind aus Spinellen der Elemente Magnesium, Aluminium und Mangan, also aus Mischoxiden zweiwertiger und dreiwertiger Metallionen aufgebaut und zählen zu den anodischen Konversionsschichten. Die spröden Schichten bauen sich etwa zur Hälfte in den Werkstoff hinein und zur Hälfte nach außen auf. HAE-Schichten werden als Verschleißschutz und als Korrosionsschutz aufgebracht und dienen auch als Haftgrund für Lacke.

Das Galvanisieren von Magnesium ist wesentlich schwieriger als beispielsweise das Abscheiden von metallischen Überzügen auf Stahl oder Messing. Die für diese Werkstoffe üblicherweise verwendeten Bäder sind für Magnesiumlegierungen ungeeignet. Es kommt aufgrund der chemischen Aktivität von Magnesium in solchen Bädern zu einer spontanen Tauchabscheidung von losen, schlecht haftenden Schichten.

Die Wirkungsweise der Beschichtungen auf Basis von organischen Lacken beruht hauptsächlich auf der Hemmung des Zutritts der korrosionsfördernden Verbindungen Wasser und Sauerstoff zur Metalloberfläche. Diese Durchtrittshemmung wird bestimmt durch den Diffusionswiderstand der Lackschicht und durch ihre Haftung auf dem Substrat unter Einwirkung von Feuchtigkeit, die sogenannte Naßfilmhaftung. Epoxidharze sollen für Magnesiumbauteile den besten Korrosionsschutz bieten, gefolgt von Epoxid-Polyester-Hybrid-harzen und Polyesterharzen.

Organisch beschichtete Magnesiumbauteile besitzen eine Empfindlichkeit für Filiformkorrosion und sind für diese anfälliger als Aluminiumbauteile.

Metallische und andere leitfähige Beschichtungen können im Falle eines Defekts Kontaktkorrosion verursachen.

### Zusammenfassung der Erfindung

Aufgabe der vorliegenden Erfindung ist es daher Magnesiumbauteile mit verbessertem Korrosionsschutz bereitzustellen, bei denen eine Kontaktkorrosion im Falle eines Defekts nicht auftritt. Ferner ist es Aufgabe der vorliegenden Erfindung, ein Magnesiumbauteil zur Verfügung zu stellen, dass eine Korrosionsrate von weniger als 0,01 mm/Jahr aufweist.

Gelöst wird die Aufgabe durch ein Magnesiumbauteil, dass mit einer glasartigen binären Mg-X-Legierung oder einer glasartigen ternären Mg-X-Y-Legierung beschichtet ist, wobei X ein Element ausgewählt aus der Gruppe bestehend aus den Elementen der 3. Hauptgruppe, der 3. Nebengruppe oder Seltenenerdelemente des Periodensystems ist, und Y ein Element ausgewählt aus der Gruppe bestehend aus den Elementen der 3. oder 4. Hauptgruppe, der 3. oder 4. Nebengruppe oder Seltenenerdelemente des Periodensystems ist, und wobei das Atomverhältnis Mg:X in der Primären Mg-X- Legierung 75:25 bis 60:40 und das Atomverhältnis Mg:X:Y in der ternären Mg-X-Y-Legierung 75:25:10 bis 60:40:5 beträgt.

Die Legierungen Mg-X und Mg-X-Y können auch weitere Elemente Z, etc. enthalten. Diese weiteren Elemente sollten bevorzugt jedoch nur in geringen Mengen von < 5 At.%, bevorzugter < 1 At.%, besonders bevorzugt < 0,5 At.% und am meisten bevorzugt < 0,1 At.% in der Magnesiumlegierung der Beschichtung vorliegen.

### Definitionen

Der Begriff "*Magnesiumbauteil*" bezeichnet erfindungsgemäß jegliches Bauteil, das aus Magnesiummetall oder einer Magnesiumlegierung gefertigt ist. Dabei kann es sich um Bauteile für Kraftfahrzeuge, Flugzeuge, Schiffe, Maschinen oder Ähnliches, aber auch um medizinische Implantate wie Knochenimplantaten oder Ähnliches handeln. Die Magnesiumlegierung des Magnesiumbauteils kann jegliche Menge z.B. von 1 bis 100 Atom% (At.%) Magnesium enthalten. Vorzugsweise enthält die Magnesiumlegierung des Magnesiumbauteils mindestens 50 At.%, besonders bevorzugt mindestens 70 Atom% Magnesium. Es ist bevorzugt, aber nicht notwendig, dass die Magnesiumlegierung weiterhin mindestens ein Element ausgewählt aus der Gruppe bestehend aus den Elementen der 3. Hauptgruppe, der 3. Nebengruppe oder Seltenenerdelemente des Periodensystems enthält. Beispielsweise kann das Magnesiumbauteil aus einer AZ31-, AZ91-, AE42-, ZM21-, ZK31-, ZE41- Legierung oder jeder anderen gängigen Magnesiumlegierung gefertigt sein.

Der Begriff *"glasartig", "glasartige Legierung"* oder *"metallisches Glas"* ist in der Technik geläufig und bezeichnet eine amorphe Legierung, die sich dadurch auszeichnet, dass sie keine Kristallstruktur ausbilden und das Material in einer Art Anordnung ohne Periodizität, d. h. ohne Fernordnung, ähnlich den Atomen in einer Schmelze, verbleibt. Auch wenn die Legierungen als amorph bezeichnet werden, so besitzen sie doch immer eine ausgeprägte Nahordnung, sowohl topologisch wie auch chemisch.

Der Begriff *"3. Hauptgruppe des Periodensystems"* umfasst die Elemente Bor (B), Aluminium (A1), Gallium (Ga), Indium (In), und Thallium (Tl). Der Begriff *"4. Hauptgruppe des Periodensystems"* umfasst die Elemente Kohlenstoff (C), Silizium (Si), Germanium (Ge), Zinn (Sn) und Blei (Pb). Der Begriff *"3. Nebengruppe des Periodensystems"* umfasst die Elemente Scandium (Sc), Yttrium (Y), Lanthan (La) und Actinium (Ac). Der Begriff *"4. Nebengruppe des Periodensystems"* umfasst die Elemente Titan (Ti), Zirkonium (Zr) und Hafnium (Hf). Der Begriff *"Seltenenerdelemente"* umfasst die Elemente der Lanthanoide und die Elemente der Actinide. Unter der Sammelbezeichnung *"Lanthanoide"* werden vorliegend die 14 auf Lanthan folgenden Elemente, nämlich Cer (Ce), Praseodym (Pr), Neodym (Nd), Promethium (Pm), Samarium (Sm), Europium (Eu), Gadolinium (Gd), Terbium (Tb), Dysprosium (Dy), Holmium (Ho), Erbium (Er), Thulium (Tm), Ytterbium (Yt) und Lutetium (Lu) verstanden. Diese liegen häufig als Mischmetalle vor. Im Zusammenhang der vorliegenden Erfindung umfasst der Begriff "Seltenerdelement" auch Mischmetalle der Seltenen Erden oder Lanthanoiden. Das Bedeutet, dass ein solches Mischmetall als "ein Element" X bzw. Y aufgefasst werden kann.

### Detaillierte Beschreibung der Erfindung

Die vorliegende Erfindung betrifft Magnesiumbauteile, die mit einer glasartigen binären Mg-X-Legierung oder einer glasartigen ternären Mg-X-Y-Legierung beschichtet sind, wobei X ein Element ausgewählt aus der Gruppe bestehend aus den Elementen der 3. Hauptgruppe, der 3. Nebengruppe oder Seltenenerdelemente des Periodensystems ist, und Y ein Element ausgewählt aus der Gruppe bestehend aus den Elementen der 3. oder 4. Hauptgruppe, der 3. oder 4. Nebengruppe oder Seltenenerdelemente des Periodensystems ist. Bevorzugt werden die Bauteile mit einer binären Mg-X-Legierung beschichtet, wobei besonders bevorzugt X aus der Gruppe bestehend aus Al, Gd, La und einem Mischmetall der Gruppe der Lanthanoiden ausgewählt ist. Die Bauteile können alternativ mit einer ternären Mg-X-Y-Legierung beschichtet werden, wobei besonders bevorzugt X aus der Gruppe bestehend aus Al, Gd, La und einem Mischmetall der Gruppe der Lanthanoiden ausgewählt ist und Y aus der Gruppe bestehend aus B, Si, Zr ausgewählt oder ein weiteres Element aus der Gruppe bestehend aus Al, Gd oder La ist.

Die Atomverhältnisse bei der binären Legierung Mg-X liegen bei 75-60 Mg:25-40 X, und bei der ternären Legierung Mg-X-Y bei 75-60 Mg:25-40 X:10-5 Y. Die Korrosionseigenschaften der hergestellten Schichten weisen besonders niedrige Korrosionsraten auf, wenn die Gehalte der Komponenten Mg-X bzw. Mg-X-Y etwa dem Gehalt der intermetallischen Phasen entsprechen, die sich laut Zustandsdiagramm im thermodynamischen Gleichgewicht bilden würden.

Gemäß einer ersten Ausführungsform werden die Bauteile mit einer binären Mg-X-Legierung beschichtet, in der X Al ist. Aufgrund der Möglichkeit, dass galvanische Korrosion auftritt, sollte das Potential der Beschichtung niedriger sein, als das des Substrats.

Eine weitere Optimierung wird erreicht, wenn ein weiteres Element zur Bildung einer Mg-X-Y-Legierung zulegiert wird, in der Y ein Element ausgewählt aus der Gruppe bestehend aus den Elementen der 3. oder 4. Hauptgruppe, der 3. oder 4. Nebengruppe oder Seltenenerdelemente des Periodensystems ist. Vorzugsweise ist Y ausgewählt aus der Gruppe bestehend aus Zr und La. Der Gehalt an Y beträgt 5 bis 10 At.%.

Gemäß einer zweiten Ausführungsform werden die Bauteile mit einer binären Mg-X-Legierung beschichtet, in der X Gd ist. Eine weitere Optimierung wird erreicht, wenn ein weiteres Element unter Bildung einer Mg-X-Y-Legierung zulegiert wird, in der Y ein Element ausgewählt aus der Gruppe bestehend aus den Elementen der 3. oder 4. Hauptgruppe, der 3. oder 4. Nebengruppe oder Seltenenerdelemente des Periodensystems ist. Vorzugsweise ist Y ausgewählt aus der Gruppe bestehend aus B, Si, Zr und Al. Der Gehalt an Y beträgt 5 bis 10 At.%.

Gemäß einer dritten Ausführungsform werden die Bauteile mit einer binären Mg-X-Legierung beschichtet, in der X La ist. Eine weitere Optimierung wird erreicht, wenn ein weiteres Element unter Bildung einer Mg-X-Y-Legierung zulegiert wird, in der Y ein Element ausgewählt aus der Gruppe bestehend aus den Elementen der 3. oder 4. Hauptgruppe, der 3. oder 4. Nebengruppe oder Seltenenerdelemente des Periodensystems ist. Vorzugsweise ist Y ausgewählt aus der Gruppe bestehend aus B, Si, Zr und Al. Der Gehalt an Y beträgt 5 bis 10 At.%.

Die erfindungsgemäßen Beschichtungen lassen sich mittels physikalischen Gasabscheidungsverfahren, vorzugsweise durch Kathodenstrahlzerstäuben (Sputtern) herstellen. Kathodenstrahlzerstäubungsverfahren (Sputterverfahren) zum Beschichten von Substraten, bei welchen in einer Vakuumkammer durch ein Plasma Ionen, vorzugsweise Edelgasionen wie Argonionen erzeugt werden, die in Richtung einer Kathode beschleunigt werden und dort auf ein zu zerstäubendes Material, nämlich den Beschichtungswerkstoff (Target) auftreffen, sind allgemein bekannt. Ein derartiges Verfahren wird beispielsweise in der EP 1 826 811 Al beschrieben, auf die hier Bezug genommen wird. Vorzugsweise wird unter dem Target ein Magnet angebracht (Magnetronzerstäubung, Magnetronsputtering). Dies hat den Vorteil, dass keine Entmischung von Legierungen auftritt.

Vorzugsweise werden Kombinationen zweier Beschichtungswerkstoffe zur Erzeugung einer binären Mg-X-Legierung auf der Oberfläche des Bauteils verwendet. Der Begriff "*Kombination*" bedeutet im vorliegenden Zusammenhang eine Kombination von mindestens zwei getrennten Beschichtungsstoffen (Targets), die durch unterschiedliche Kathodenstrahlen zerstäubt werden. So wird beispielsweise eine Kombination von Magnesium als ein erster Beschichtungsstoff und mindestens eines zweiten Beschichtungsstoffs bevorzugt verwendet, wobei der zweite Beschichtungsstoff (X) ein Element ausgewählt aus der Gruppe bestehend aus den Elementen der 3. Hauptgruppe, der 3. Nebengruppe oder Seltenenerdelemente des Periodensystems ist, und Y ein Element ausgewählt aus der Gruppe bestehend aus den Elementen der 3. oder 4. Hauptgruppe, der 3. oder 4. Nebengruppe oder Seltenenerdelemente des Periodensystems ist. Der erste und der zweite Beschichtungswerkstoff werden vorzugsweise durch Kathodenstrahlen zerstäubt, die durch unterschiedliche Generatoren erzeugt werden.

Ähnliches gilt auch für die Erzeugung einer ternären Mg-X-Y-Legierung auf der Oberfläche des Bauteils. Dazu wird bevorzugt eine Kombination von Magnesium als ein erster Beschichtungsstoff, eines zweiten Beschichtungsstoffs (X) und eines dritten Beschichtungsstoffs (Y) bevorzugt verwendet, wobei X wie oben definiert und Y ein Element ausgewählt aus der Gruppe bestehend aus den Elementen der 3. oder 4. Hauptgruppe, der 3. oder 4. Nebengruppe oder Seltenenerdelemente des Periodensystems ist. Zur Herstellung können gleichwertig auch Legierungstargets entsprechender Zusammensetzung der glasartigen binären oder ternären oder komplexeren Legierungsschicht verwendet werden oder mehrere Legierungstargets unterschiedlicher Zusammensetzung, die erst auf dem Substrat die gewünschte Schichtzusammensetzung ergeben.

Vor dem Kathodenstrahlzerstäuben befinden sich die Proben im Hochvakuum einer Anlage, vorzugsweise bei einem Basisdruck von weniger als 10⁻⁷ mbar. Das erforderliche Sputtergas ist vorzugsweise Argon und der bevorzugte Sputtergasdruck beträgt 0,0001 bis 1 mbar. Somit erfolgt der Abtrag vom Target, das Kathodenstrahlzerstäuben, mit einer kinetischen Energie der Ar-Ionen von bevorzugt 5 bis 50 eV, insbesondere 5 bis 10 eV.

Das erfindungsgemäße Verfahren ermöglicht hohe Abschreckraten im Bereich von höher als etwa 10⁶ K/s. Bei Einstellung der erfindungsgemäß bevorzugten Abschreckraten von höher als etwa 10⁶ K/s bilden sich die erfindungsgemäßen glasartigen Legierungen mit Korngrößen im Bereich von vorzugsweise < 10 nm (bestimmt mittels Transmissionselektronenmikroskopie), die keine Fernordnung erkennen lassen. Eine solche Gefügestruktur kann nicht durch konventionelle Beschichtungsverfahren hergestellt werden.

Die bevorzugte Schichtdicke der Beschichtung beträgt etwa 5 nm bis 500 µm, besonders bevorzugt 1 bis 10 µm.

Die erfindungsgemäßen Magnesiumbauteile haben eine geringe Korrosionsrate von weniger als 0,01 mm/Jahr. Ferner ist ein kathodischer Korrosionsschutz der Magnesiumbauteile vorhanden.

Die Erfindung wird nunmehr anhand der folgenden Beispiele erläutert, die die Erfindung nicht einschränken sollen.

### Vergleichendes Beispiel 1

Es wurden verschiedene Magnesium-Aluminium-Beschichtungen mit unterschiedlichen Mg:Al-Verhältnissen auf Silizium und AZ31-Legierungen hergestellt, indem zwei unterschiedliche Targets, nämlich ein Mg-Target und ein Al-Target, mit Kathodenstrahlen unterschiedlicher Energie besputtert wurden. Die Beschichtungsdicke betrug etwa 3 µm, das Vakuum betrug vorher etwa 10⁻⁷ mbar, das Sputtergas war Argon, das mit einem Gasdruck von 0,2 Pa verwendet wurde.

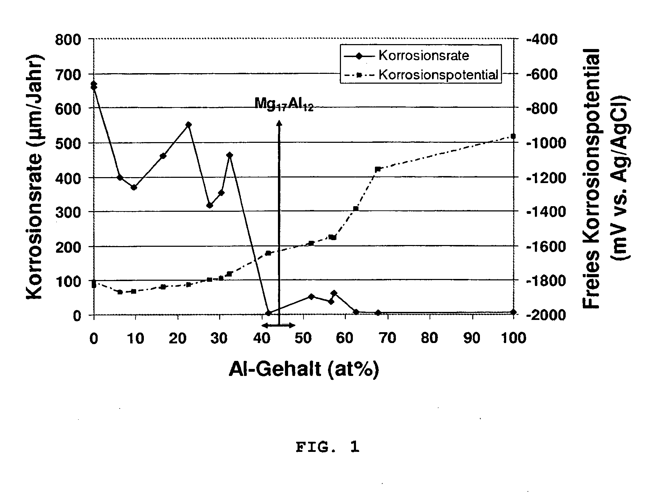

Figur 1 zeigt die Korrosionsrate (durchgezogenen Line) in µm/Jahr und das freie Korrosionspotential (gestrichelte Linie) in mV in Abhängigkeit der Aluminiumkonzentration (in Gew.%) der Beschichtung. Das Korrosionspotential der Beschichtung liegt im Bereich von 0 bis 50 Gew.% unter dem Potential des Substrats (AZ31), was die Gefahr einer galvanischen Korrosion herabsetzt. Eine gute Passivierung ist im Bereich von 40-50 At.% Al gegeben. In diesem Bereich besitzen die Schichten ebenfalls sehr niedrige Korrosionsraten mit einem Minimum von etwa 5 µm/Jahr.

Die nachfolgende Tabelle 1 gibt einen Überblick über verschiedene Eigenschaften der Legierungen:

**Tabelle 1**

| Mg: Leistung / W | Al: Leistung / W | Mg-Beschichtungsrate/nm/s | Al-Beschichtungsrate/nm/s | Al-Konz. / wt.% | Schicht - dicke/ µm | Rauigkeit/nm | dₕₖₗ nm | Korn größe/nm | erhaltene Phasen | Freies Korrosionspotential/mV | Korrosions-rate/µm/Jahr | Passivstromdichte/ mA/cm² | Durchbruchpotential/ mV |
|---|---|---|---|---|---|---|---|---|---|---|---|---|---|
| 160 | 0 | 0.815 | 0 | 0 | 2.5 | 33 | 2.608 | 29 | hcp-Mg | -1832 | 671 | aktive Auflösung | aktive Auflösung |
| 130 | 30 | 0.743 | 0.085 | 7 | 2.8 | 1.0 | 2.587 | 31 | Mg(Al) | -1870 | 399 | aktive Auflösung | aktive Auflösung |
| 160 | 60 | 0.387 | 0.095 | 11 | 2.8 | 1.3 | 2.578 | 27 | Mg(Al) | -1866 | 369 | aktive Auflösung | aktive Auflösung |
| 160 | 80 | 0.924 | 0.183 | 13 | 3.1 | 1.1 | 2.558 | 21 | Mg(Al) | -1841 | 460 | 0.0689 | -1433 |
| 160 | 140 | 0.920 | 0.269 | 25 | 3.3 | 2.0 | 2.550 | 28 | Mg(Al)+Al(Mg) | -1829 | 551 | 0.0469 | -1426 |
| 160 | 180 | 0.383 | 0.339 | 30 | 3.2 | 0.8 | 2.553 | 28 | Mg(Al)+Al(Mg) | -1799 | 316 | 0.0312 | -1366 |
| 160 | 180 | 0.750 | 0.330 | 33 | 3.0 | 0.6 | 2.554 | 27 | Mg(Al)+Al(Mg) | -1790 | 354 | 0.0323 | -1315 |
| 140 | 180 | 0.683 | 0.326 | 35 | 3.0 | 1.0 | 2.555 | 24 | Mg(Al)+Al(Mg) | -1764 | 462 | 0.0222 | -1262 |
| 90 | 180 | 0.440 | 0.314 | 44 | 3.2 | 1.0 | 2.545 | 13 | Mg(Al)+Al(Mg) | -1647 | 4 | 0.0027 | -1036 |
| 60 | 180 | 0.236 | 0.309 | 55 | 3.2 | 1.1 | 2.558 | 10 | Mg(Al)+Al(Mg) | -1590 | 52 | 0.0041 | -800 |
| 45 | 176 | 0.222 | 0.290 | 59 | 3.0 | 1.3 | | <10 | nanokristallin | -1550 | 36 | 0.0038 | -796 |
| 50 | 180 | 0.225 | 0.302 | 60 | 3.8 | 1.0 | | <10 | nanokristallin | -1557 | 62 | 0.0053 | -803 |
| 30 | 180 | 0.143 | 0.246 | 65 | 3.0 | 0.9 | | <10 | nanokristallin | -1387 | 5 | 0.0130 | -790 |
| 20 | 180 | 0.131 | 0.275 | 70 | 2.9 | 2.1 | | <10 | nanokristallin | -1157 | 4 | 0.0095 | -774 |
| 0 | 270 | 0.145 | 0.278 | 100 | 3.4 | 1.5 | 2.338 | 31 | fcc-Al | -969 | 6 | 0.0028 | -632 |

### Vergleichendes Beispiel 2

Eine weitere Optimierung der Korrosionseigenschaften kann erzielt werden, wenn man ein weiteres Element unter Ausbildung einer Mg-Al-Y-Legierung zulegiert. Vorliegend wurde die Korrosionsrate bei unterschiedlichen Lanthangehalten untersucht:

| At.% Mg | At.% Al | At.% La | Korrosionsrate (µm/Jahr) |
|---|---|---|---|
| 91,3 | 7, 6 | 1, 1 | 154 |
| 52 | 36,9 | 11,1 | 16 |
| 45,3 | 53,3 | 1, 4 | 122 |
| 43, 1 | 53, 8 | 3,1 | 123 |
| 41,8 | 36,3 | 21,9 | 21 |

### Beispiel 3

Wie in Beispiel 1 wurden binäre Magnesium-Gadolinium-Beschichtungen mit unterschiedlichen Mg:Gd-Verhältnissen hergestellt.

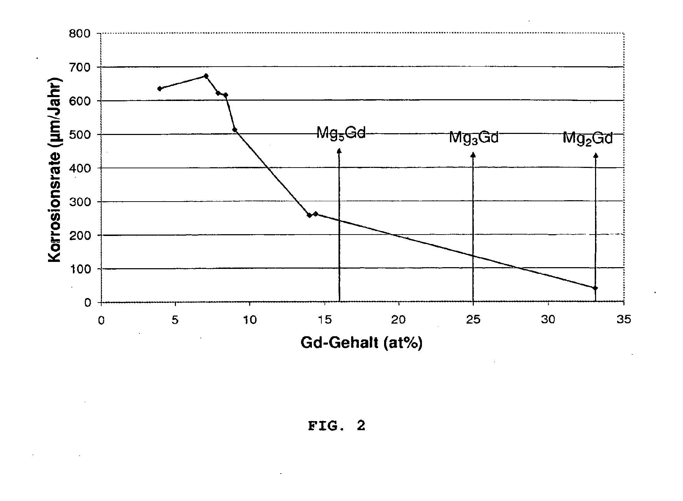

Figur 2 zeigt die Korrosionsrate in mm/Jahr in Abhängigkeit der Gadoliniumkonzentration (in At.%) der Beschichtung.

Wie im System Mg-Al sinkt auch die Korrosionsrate im System Mg-Gd deutlich, sobald die Gefügestruktur der Beschichtung nanokristallin/amorph wird.

### Vergleichendes Beispiel 4

Auch im System Mg-Gd kann die Zugabe eines dritten Elements die Korrosion weiter reduzieren, wie die folgende Tabelle zeigt:

| At.% Mg | At.% Gd | At.% Y | Korrosionsrate (µm/Jahr( |
|---|---|---|---|
| | | Y = B | |
| 56,2 | 42,3 | 1,5 | 7 |
| 51 | 42,6 | 6, 4 | 31 |
| | | Y = Si | |
| 63,2 | 34,6 | 2,2 | 19 |
| 62 | 30, 7 | 7,3 | 77 |
| 59,8 | 34,2 | 6, 1 | 40 |
| | | Y = Zr | |
| 69,1 | 28,6 | 2,3 | 32 |
| 65 | 29 | 6, 1 | 72 |
| 61,3 | 32,6 | 6, 1 | 118 |
| | | X = Al | |
| 66,2 | 27,5 | 6, 4 | 46 |
| 62,5 | 26,5 | 11 | 77 |

### Beispiel 5

Wie in Beispielen 1 und 3 wurden binäre Magnesium-Lanthan-Beschichtungen mit unterschiedlichen Mg:La-Verhältnissen hergestellt.

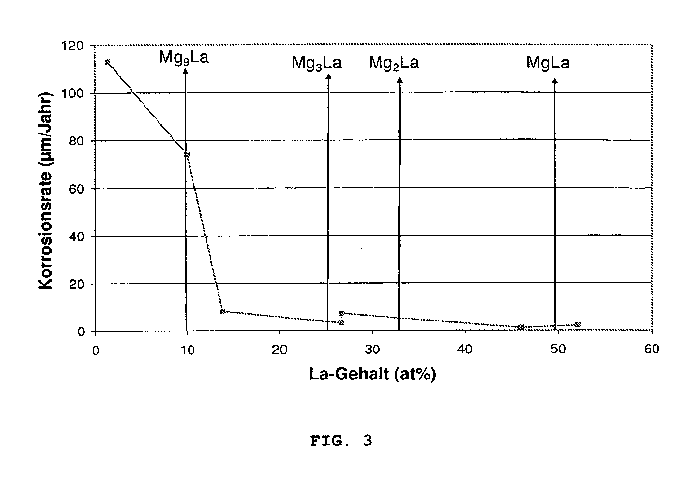

Figur 3 zeigt die Korrosionsrate in µm/Jahr in Abhängigkeit der Lanthankonzentration (in At.%) der Beschichtung.

Mit Lanthan sind bessere Ergebnis erzielbar, als mit Gadolinium. Besonders niedrige Korrosionsraten treten auch hier wieder im glasartigen Zustand auf.

## Patentansprüche

1. Bauteil aus Magnesiummetall oder einer Magnesiumlegierung, das mit einer glasartigen binären Mg-X-Legierung oder einer glasartigen ternären Mg-X-Y-Legierung beschichtet ist, wobei X ein Element ausgewählt aus der Gruppe bestehend aus den Elementen der 3. Hauptgruppe, der 3. Nebengruppe oder Seltenenerdelemente des Periodensystems ist, und Y ein Element ausgewählt aus der Gruppe bestehend aus den Elementen der 3. oder 4. Hauptgruppe, der 3. oder 4. Nebengruppe, Lanthaniden oder Actiniden des Periodensystems ist und wobei das Atomverhältnis Mg:X in der binären Mg-X-Legierung 75:25 bis 60:40 und das Atomverhältnis Mg:X:Y in der ternären Mg-X-Y-Legierung 75:25:10 bis 60:40:5 beträgt.

2. Bauteil nach Anspruch 1, das mit einer glasartigen binären Mg-X-Legierung beschichtet ist, wobei X aus der Gruppe bestehend aus Al, Gd, La und einem Mischmetall der Gruppe der Lanthanoiden ausgewählt ist.

3. Bauteil nach Anspruch 1, das mit einer glasartigen ternären Mg-X-Y-Legierung beschichtet ist, wobei X aus der Gruppe bestehend aus Al, Gd, La und einem Mischmetall der Gruppe der Lanthanoiden ausgewählt ist und Y aus der Gruppe bestehend aus B, Si, Zr ausgewählt oder ein weiteres Element aus der Gruppe bestehend aus Al, Gd oder La ist.

4. Bauteil nach einem der vorgehenden Ansprüche, wobei die Schichtdicke der Beschichtung 5 nm bis 500 µm beträgt.

5. Bauteil nach einem der vorgehenden Ansprüche, das aus einer Magnesiumlegierung hergestellt ist, die mehr als 70 At.% Magnesium enthält.

6. Bauteil nach Anspruch 5, wobei die Magnesiumlegierung eine AZ31-Legierung ist.

7. Verfahren zur Erzeugung einer Beschichtung mit einer glasartigen binären Mg-X-Legierung oder einer glasartigen ternären Mg-X-Y-Legierung auf einem Bauteil aus Magnesiummetall oder einer Magnesiumlegierung mittels physikalischem Gasabscheidungsverfahren, wobei X und Y wie in Anspruch 1 definiert sind.

8. Verfahren nach Anspruch 7, **dadurch gekennzeichnet, dass** als physikalische Gasabscheidungsverfahren ein Kathodenstrahlzerstäubungsverfahren (Sputterverfahren) angewendet wird.

9. Verfahren nach Anspruch 8, **dadurch gekennzeichnet, dass** das Sputterverfahren ein Magnetronsputterverfahren ist.

10. Verfahren nach einem der Ansprüche 8 oder 9, **dadurch gekennzeichnet, dass** die Erzeugung der Beschichtung mit einer glasartigen binären Mg-X-Legierung oder einer glasartigen ternären Mg-X-Y-Legierung durch ein kombinatorisches Verfahren mit Elementtargets entsprechend der Anzahl der Komponenten erfolgt, wobei die jeweiligen Generatoren in der Leistung gesteuert werden, um die gewünschte günstige Zusammensetzung zu erzielen.

11. Verfahren nach einem der Ansprüche 8 oder 9, **dadurch gekennzeichnet, dass** die Erzeugung der Beschichtung mit einer glasartigen binären Mg-X-Legierung oder einer glasartigen ternären Mg-X-Y-Legierung durch Einsatz eines oder mehrerer Legierungstargets erfolgt.

## Claims

1. Component made of magnesium metal or a magnesium alloy, which is coated with a vitreous binary Mg-X alloy or a vitreous ternary Mg-X-Y alloy, where X is an element selected from the group consisting of the elements of main group III, of transition group III or rare earth elements of the Periodic Table of the Elements, and Y is an element selected from the group consisting of the elements of main group III or IV, of transition group III or IV, the group of the lanthanides or the group of the actinides of the Periodic Table of the Elements, and wherein the atomic ratio Mg:X in the binary Mg-X alloy is 75:25 to 60:40 and the atomic ratio Mg:X:Y in the ternary Mg-X-Y alloy is 75:25:10 to 60:40:5.

2. Component according to Claim 1, which is coated with a vitreous binary Mg-X alloy, where X is selected from the group consisting of Al, Gd, La and a mixed metal of the group of the lanthanides.

3. Component according to Claim 1, which is coated with a vitreous ternary Mg-X-Y alloy, where X is selected from the group consisting of Al, Gd, La and a mixed metal of the group of the lanthanides and Y is selected from the group consisting of B, Si and Zr or is a further element from the group consisting of Al, Gd or La.

4. Component according to one of the preceding claims, wherein the layer thickness of the coating is 5 nm to 500 µm.

5. Component according to one of the preceding claims, which is produced from a magnesium alloy containing more than 70 at.% of magnesium.

6. Component according to Claim 5, wherein the magnesium alloy is an AZ31 alloy.

7. Process for producing a coating comprising a vitreous binary Mg-X alloy or a vitreous ternary Mg-X-Y alloy on a component made of magnesium metal or a magnesium alloy by means of a physical vapor deposition process, where X and Y are defined as in Claim 1.

8. Process according to Claim 7, **characterized in that** a cathode ray atomization process (sputtering process) is used as the physical vapor deposition process.

9. Process according to Claim 8, **characterized in that** the sputtering process is a magnetron sputtering process.

10. Process according to either of Claims 8 and 9, **characterized in that** the coating comprising a vitreous binary Mg-X alloy or a vitreous ternary Mg-X-Y alloy is produced by a combinational process with element targets according to the number of components, wherein the power of the respective generators is controlled so as to achieve the desired favorable composition.

11. Process according to either of Claims 8 and 9, **characterized in that** the coating comprising a vitreous binary Mg-X alloy or a vitreous ternary Mg-X-Y alloy is produced by using one or more alloy targets.

## Revendications

1. Élément de construction à base de métal magnésium ou d'un alliage de magnésium, qui est revêtu avec un alliage binaire Mg-X vitreux ou un alliage ternaire Mg-X-Y vitreux, X étant un élément choisi dans le groupe constitué par les éléments du groupe IIIA, du groupe IIIB ou des terres rares du tableau périodique des éléments, et Y étant un élément choisi dans le groupe constitué par les éléments du groupe IIIA ou IVA, ou du groupe IIIB ou IVB, les lanthanides ou les actinides du tableau périodique des éléments, et le rapport atomique Mg:X dans l'alliage binaire Mg-X valant de 75:25 à 60:40 et le rapport atomique Mg:X:Y dans l'alliage ternaire Mg-X-Y valant de 75:25:10 à 60:40:5.

2. Élément de construction selon la revendication 1, qui est revêtu avec un alliage biriaire Mg-X vitreux, X étant choisi dans le groupe constitué par Al, Gd, La et un mischmétal du groupe des lanthanides.

3. Élément de construction selon la revendication 1, qui est revêtu avec un alliage ternaire Mg-X-Y vitreux, X étant choisi dans le groupe constitué par Al, Gd, La et un mischmétal du groupe des lanthanides et Y étant choisi dans le groupe constitué par B, Si, Zr ou un autre élément choisi dans le groupe constitué par Al, Gd ou La.

4. Élément de construction selon l'une quelconque des revendications précédentes, dans lequel l'épaisseur de couche du revêtement vaut de 5 nm à 500 µm.

5. Élément de construction selon l'une quelconque des revendications précédentes, qui est produit à partir d'un alliage de magnésium qui contient plus de 70 % en atomes de magnésium.

6. Élément de construction selon la revendication 5, dans lequel l'alliage de magnésium est un alliage AZ31.

7. Procédé pour la production d'un revêtement avec un alliage binaire Mg-X vitreux ou un alliage ternaire Mg-X-Y vitreux sur un élément de construction à base de métal magnésium ou d'un alliage de magnésium, au moyen d'un procédé de dépôt physique en phase vapeur, X et Y étant tels que définis dans la revendication 1.

8. Procédé selon la revendication 7, **caractérisé en ce qu'**on utilise comme procédé de dépôt physique en phase vapeur un procédé de pulvérisation par jet cathodique (procédé de pulvérisation cathodique).

9. Procédé selon la revendication 8, **caractérisé en ce que** le procédé de pulvérisation cathodique est un procédé de pulvérisation cathodique par magnétron.

10. Procédé selon l'une quelconque des revendications 8 et 9, **caractérisé en ce qu'**on effectue la production du revêtement avec un alliage binaire Mg-X vitreux ou un alliage ternaire Mg-X-Y vitreux par un procédé combinatoire avec des cibles d'éléments correspondant au nombre des composants, en réglant la puissance des générateurs respectifs de manière à réaliser la composition favorable souhaitée.

11. Procédé selon l'une quelconque des revendications 8 et 9, **caractérisé en ce qu'**on effectue la production du revêtement avec un alliage binaire Mg-X vitreux ou un alliage ternaire Mg-X-Y vitreux en utilisant une ou plusieurs cibles en alliage.
